# EUROPEAN PATENT APPLICATION

(11) **EP 2 302 986 A1**
(43) Date of publication of application: **30.03.2011**
(21) Application number: 10176401.7
(22) Date of filing: 13.09.2010
(51) Int. Cl.: H05K 1/03, H01M 8/02

(54) **Printed circuit board and fuel cell**

(30) Priority: 25.09.2009 JP 2009221109; 10.09.2010 JP 2010202565
(71) Applicant: NITTO DENKO CORPORATION, Ibaraki-shi, Osaka 567-8680 (JP)
(72) Inventor: Hanazono, Hiroyuki, Ibaraki-shi Osaka 567-8680 (JP); Inoue, Shinichi, Ibaraki-shi Osaka 567-8680 (JP)
(74) Representative: Gill, Stephen Charles

(57) **Abstract**

An FPC board (1) includes a base insulating layer (2). The base insulating layer (2) is composed of a first insulating portion (2a) and a second insulating portion (2b). A bend portion (B1) is provided in the first insulating portion. A conductor layer (3) is formed on one surface of the base insulating layer (2). The conductor layer (3) is composed of a collector portion (3a,3b) and a drawn-out conductor portion (4a,4b). A cover layer (6a,6b) is formed to cover the conductor layer (3). A liquid crystal polymer is used as a material for the base insulating layer (2).

## Description

### BACKGROUND OF THE INVENTION

### Field of the Invention

The present invention relates to a printed circuit board and a fuel cell using the same.

### Description of the Background Art

Batteries that are small in size and have high capacity are desired for mobile equipment such as cellular telephones. Therefore, fuel cells capable of providing higher energy density than conventional batteries such as lithium secondary batteries have been developed. Examples of the fuel cells include a direct methanol fuel cell.

In the direct methanol fuel cell, methanol is decomposed by a catalyst, forming hydrogen ions. The hydrogen ions are reacted with oxygen in the air to generate electrical power. In this case, chemical energy can be converted into electrical energy with extremely high efficiency, so that significantly high energy density can be obtained.

A flexible printed circuit board (hereinafter abbreviated as an FPC board), for example, is provided as a collector circuit within such a direct methanol fuel cell (see JP 2004-200064 A, for example).

The FPC board is configured to have a conductor layer formed on a base insulating layer. Part of the FPC board is drawn out of the fuel cell. Various external circuits are connected to the part of the FPC board that is drawn out of the fuel cell.

Polyimide is used as the base insulating layer of the FPC board. However, polyimide has high moisture absorption. Therefore, when the FPC board having the base insulating layer made of polyimide is used in the fuel cell, malfunctions described below may occur.

For example, water vapor in the atmosphere or another liquid is absorbed into the base insulating layer in the outside of the fuel cell. The liquid enters the fuel cell via the base insulating layer of the FPC board as impurities. Thus, the impurities are mixed into methanol that is supplied to the fuel cell as a fuel, resulting in degradation in performance of the fuel cell.

Moreover, methanol may be absorbed into the base insulating layer of the FPC board in the fuel cell, and the methanol may leak out of the fuel cell via the base insulating layer of the FPC board.

Furthermore, the base insulating layer may expand by absorbing the liquid, causing the conductor layer to be detached from the base insulating layer.

### BRIEF SUMMARY OF THE INVENTION

An object of the present invention is to provide a printed circuit board in which malfunctions to be caused by absorption of liquids into a base insulating layer are prevented and a fuel cell including the same.
(1) According to an aspect of the present invention, a printed circuit board to be used in a fuel cell includes an insulating layer made of a liquid crystal polymer, and a conductor layer provided on the insulating layer, wherein the conductor layer includes a collector portion, and an electrode portion extending from the collector portion.

In the printed circuit board, the conductor layer including the collector portion and the electrode portion is provided on the insulating layer made of the liquid crystal polymer. The liquid crystal polymer has lower moisture absorption than general resin materials such as polyimide. Therefore, in the case of employing the printed circuit board in the fuel cell, a liquid can be prevented from being absorbed into the insulating layer of the printed circuit board in the outside of the fuel cell and entering the fuel cell via the insulating layer of the printed circuit board. This inhibits impurities from being mixed into a fuel supplied to the fuel cell. As a result, degradation in performance of the full cell can be suppressed.

In addition, the fuel supplied to the fuel cell can be prevented from being absorbed into the insulating layer of the printed circuit board and leaking out of the fuel cell. Furthermore, expansion of the insulating layer due to absorption of a liquid into the insulating layer can be suppressed, thus inhibiting the conductor layer from being detached from the insulating layer.
(2) The liquid crystal polymer may have a molecular structure represented by a formula (1) shown below: 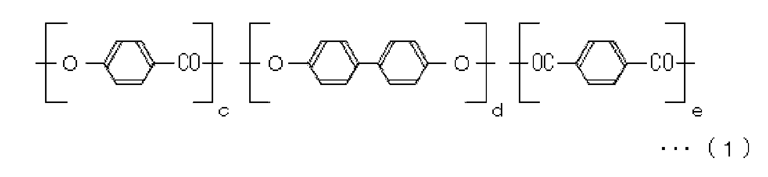
where a molar ratio [c/(c+d+e)] is preferably not less than 0.5 and not more than 0.8, a molar ratio [d/(c+d+e)] is preferably not less than 0.01 and not more than 0.49, and a molar ratio [e/(c+d+e)] is preferably not less than 0.01 and not more than 0.49.

In this case, the insulating layer has high heat resistance. Therefore, when the printed circuit board is used in the fuel cell, the insulating layer can be prevented from deforming even though the temperature of the insulating layer rises because of heat generated by a chemical reaction.
(3) The liquid crystal polymer may have a molecular structure represented by a formula (2) shown below: 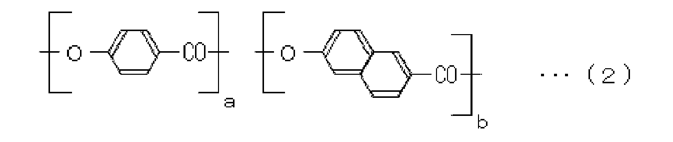
where a molar ratio [a/(a+b)] is preferably not less than 0.5 and not more than 0.8, and a molar ratio [b/(a+b)] is preferably not less than 0.2 and not more than 0.5.

In this case, the insulating layer has high heat resistance. Therefore, when the printed circuit board is used in the fuel cell, the insulating layer can be prevented from deforming even though the temperature of the insulating layer rises because of heat generated by a chemical reaction.
(4) The printed circuit board may further include a cover layer that is electrically conductive and resistant to acids, and is formed to cover a surface of the conductor layer.

In this case, in the fuel cell, electrical conductivity between the conductor layer and other elements can be ensured, and the conductor layer can be prevented from corroding because of acid supplied as the fuel.
(5) The cover layer may include a resin composition containing carbon.

In this case, in the fuel cell, electrical conductivity between the conductor layer and other elements can be ensured, and the conductor layer can be prevented from corroding because of acid supplied as the fuel at low cost.
(6) The cover layer may be made of a metal material that is resistant to acids.

In this case, in the fuel cell, electrical conductivity between the conductor layer and other elements can be sufficiently ensured, and the conductor layer can be prevented from corroding because of acid supplied as the fuel.
(7) The printed circuit board may further include a cover insulating layer that covers an interface between the insulating layer and the cover layer.

In this case, acid supplied as the fuel can be inhibited from coming in contact with the collector portion of the conductor layer via the interfaces between the insulating layer and the cover layer in the fuel cell. This reliably prevents the collector portion of the conductor layer from corroding.
(8) According to another aspect of the present invention, a printed circuit board to be used in a fuel cell includes an insulating layer made of a liquid crystal polymer, and a conductor layer provided on the insulating layer, wherein the conductor layer includes first and second collector portions, and first and second electrode portions extending from the first and second collector portions, respectively, and the insulating layer and the conductor layer can be bent at a portion between the first and second collector portions such that the conductor layer is positioned on an inner side.

In the printed circuit board, the conductor layer having the first and second collector portions and the first and second electrode portions is formed on the insulating layer made of the liquid crystal polymer. When the printed circuit board is used in the fuel cell, the insulating layer and the conductor layer of the printed circuit board are bent at the portion between the first and second collector portions such that the conductor layer is positioned on the inner side. The first and second electrode portions are drawn out of the fuel cell.

In this case, since the insulating layer is made of the liquid crystal polymer having low moisture absorption, a liquid can be prevented from being absorbed into the insulating layer of the printed circuit board in the outside of the fuel cell and entering the fuel cell via the insulating layer of the printed circuit board. This inhibits impurities from being mixed into a fuel supplied to the fuel cell. As a result, degradation in performance of the full cell can be suppressed.

In addition, the fuel supplied to the fuel cell can be prevented from being absorbed into the insulating layer of the printed circuit board and leaking out of the fuel cell. Furthermore, expansion of the insulating layer due to absorption of a liquid into the insulating layer can be suppressed, thus inhibiting the conductor layer from being detached from the insulating layer.
(9) According to still another aspect of the present invention, a fuel cell includes a cell element, the printed circuit board according to the another aspect of the present invention, and a housing that houses the printed circuit board and the cell element, wherein the printed circuit board is housed in the housing with the cell element arranged between the first collector portion and the second collector portion, and the first and second electrode portions are drawn out of the housing.

In the printed circuit board of the fuel cell, the conductor layer including the first and second collector portions and the first and second electrode portions is formed on the insulating layer made of the liquid crystal polymer.

The insulating layer and the conductor layer of the printed circuit board are bent at the portion between the first and second collector portions such that the conductor layer is positioned on the inner side. The cell element is arranged between the first and second collector portions of the bent printed circuit board.

In the state, the printed circuit board and the cell element are housed in the hosing, and the first and second electrode portions of the printed circuit board are drawn out of the housing. An external circuit is connected to the first and second drawn-out electrode portions.

In this case, since the insulating layer of the printed circuit board is made of the liquid crystal polymer having low moisture absorption, a liquid can be prevented from being absorbed into the insulating layer of the printed circuit board in the outside of the fuel cell and entering the fuel cell via the insulating layer of the printed circuit board. This inhibits impurities from being mixed into a fuel supplied to the fuel cell. As a result, degradation in performance of the full cell can be suppressed.

In addition, the fuel supplied to the fuel cell can be prevented from being absorbed into the insulating layer of the printed circuit board and leaking out of the fuel cell. Furthermore, expansion of the insulating layer due to absorption of a liquid into the insulating layer can be suppressed, thus inhibiting the conductor layer from being detached from the insulating layer.

According to the present invention, a liquid can be prevented from being absorbed into the insulating layer of the printed circuit board in the outside of the fuel cell and entering the fuel cell via the insulating layer of the printed circuit board. This inhibits impurities from being mixed into a fuel supplied to the fuel cell. As a result, degradation in performance of the full cell can be suppressed. In addition, the fuel supplied to the fuel cell can be prevented from being absorbed into the insulating layer of the printed circuit board and leaking out of the fuel cell. Furthermore, expansion of the insulating layer due to absorption of a liquid into the insulating layer can be suppressed, thus inhibiting the conductor layer from being detached from the insulating layer.

Other features, elements, characteristics, and advantages of the present invention will become more apparent from the following description of preferred embodiments of the present invention with reference to the attached drawings.

### BRIEF DESCRIPTION OF THE SEVERAL VIEWS OF THE DRAWINGS

Fig. 1 is a diagram showing the configuration of a flexible printed circuit board according to the present embodiment;
Fig. 2 is a sectional view for illustrating steps in a method of manufacturing the flexible printed circuit board;
Fig. 3 is a sectional view for illustrating steps in the method of manufacturing the flexible printed circuit board;
Fig. 4 is a diagram showing the configuration of a fuel cell using the flexible printed circuit board of Fig. 1;
Fig. 5 is a sectional view showing a modification of the flexible printed circuit board; and
Fig. 6 is a diagram showing results of Table 1 in graph form.

### DETAILED DESCRIPTION OF THE INVENTION

Description will be made of a printed circuit board and a fuel cell according to one embodiment of the present invention while referring to the drawings. In the present embodiment, a flexible printed circuit board having flexibility is described as an example of the printed circuit board.

### (1) Configuration of Flexible Printed Circuit Board

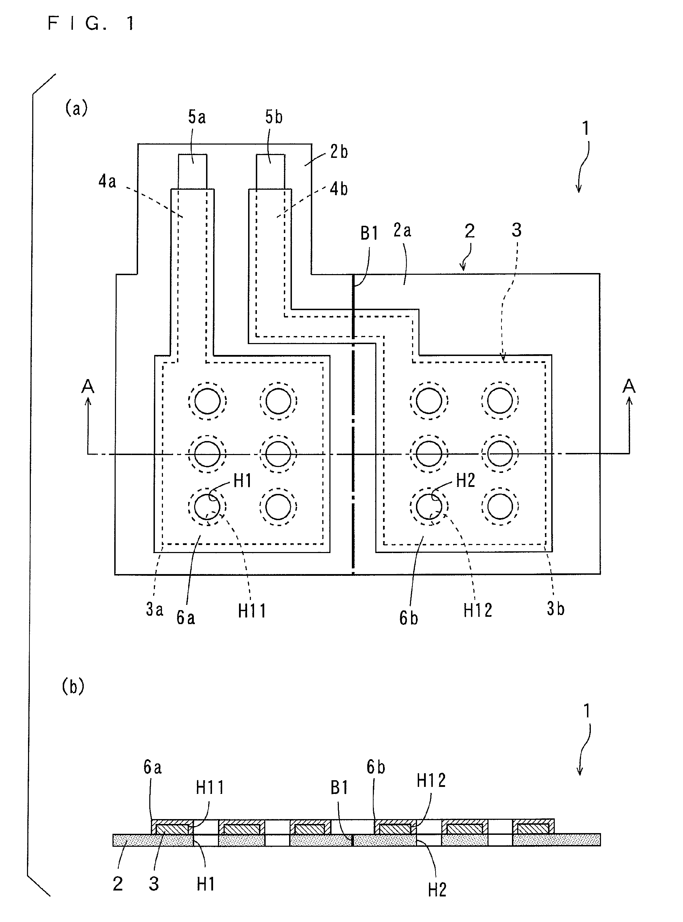

Fig. 1 (a) is a plan view of a flexible printed circuit board according to the present embodiment, and Fig. 1 (b) is a sectional view taken along the line A-A of the flexible printed circuit board of Fig. 1 (a). In the following description, the flexible printed circuit board is abbreviated as the FPC board.

As shown in Fig. 1 (a) and (b), the FPC board 1 includes a base insulating layer 2. The base insulating layer 2 is composed of a rectangular first insulating portion 2a, and a second insulating portion 2b outwardly extending from one side of the first insulating portion 2a. In the following description, the above-mentioned one side and another one side parallel thereto of the first insulating portion 2a are referred to as lateral sides, and another pair of sides perpendicular to the lateral sides of the first insulating portion 2a is referred to as end sides.

In the present embodiment, a liquid crystal polymer (LCP) is used as a material for the base insulating layer 2. More specifically, a liquid crystal polymer having a molecular structure represented by the following formula (1) (hereinafter referred to as a first liquid crystal polymer) or a liquid crystal polymer having a molecular structure represented by the following formula (2) (hereinafter referred to as a second liquid crystal polymer) is preferably used.

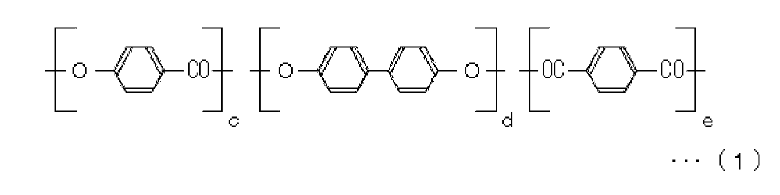

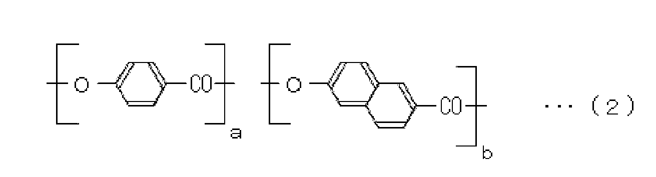

In the formula (1), the molar ratio [c/(c+d+e)] is preferably not less than 0.5 and not more than 0.8, the molar ratio [d/(c+d+e)] is preferably not less than 0.01 and not more than 0.49, and the molar ratio [e/(c+d+e)] is preferably not less than 0.01 and not more than 0.49. In the formula (2), the molar ratio [a/(a+b)] is preferably not less than 0.5 and not more than 0.8, and the molar ratio [b/(a+b)] is preferably not less than 0.2 and not more than 0.5.

The weight-average molecular weight of each of the first and second liquid crystal polymers is not less than 10000 and not more than 150000, for example, and preferably not less than 20000 and not more than 70000.

The first and second liquid crystal polymers are random copolymers, for example, and may be block copolymers, alternating copolymers, or graft copolymers.

Each of the first and second liquid crystal polymers has a deflection temperature under load, which represents heat resistance, of 260 °C or more, which is higher than those of liquid crystal polymers having other molecular structures. This prevents the base insulating layer 2 from deforming even though the temperature of the base insulating layer 2 rises because of heat generated by a chemical reaction in a fuel cell described below.

A liquid crystal polymer having a molecular structure represented by the following formula (3) (hereinafter referred to as a third liquid crystal polymer) may be used as a material for the base insulating layer 2.

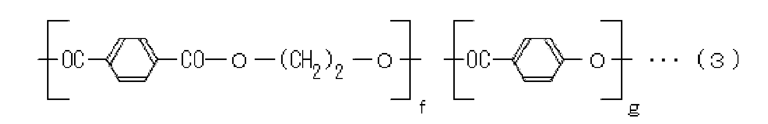

In the formula (3), the molar ratio [f/(f+g)] is preferably not less than 0.2 and not more than 0.5, and the molar ratio [g/(f+g)] is preferably not less than 0.5 and not more than 0.8.

The weight-average molecular weight of the third liquid crystal polymer is not less than 10000 and not more than 150000, for example, and preferably not less than 20000 and not more than 70000.

The third liquid crystal polymer is a random copolymer, for example, and may be a block copolymer, an alternating copolymer, or a graft copolymer.

A bend portion B1 is provided in the first insulating portion 2a of the base insulating layer 2 so as to be parallel to the end sides and to divide the first insulating portion 2a into two substantially equal parts. As will be described below, the first insulating portion 2a is bent along the bend portion B1. The bend portion B1 may be a shallow groove having a line shape, a mark having a line shape or the like, for example. Alternatively, there may be nothing at the bend portion B1 if the first insulating portion 2a can be bent at the bend portion B1. The second insulating portion 2b is formed to outwardly extend from the lateral side of one region of the first insulating portion 2a with the bend portion B1 as a boundary.

A plurality of (six in this example) openings H1 are formed in the one region of the first insulating portion 2a with the bend portion B1 as the boundary. A plurality of (six in this example) openings H2 are formed in the other region of the first insulating portion 2a with the bend portion B1 as the boundary.

A conductor layer 3 made of copper, for example, is formed on one surface of the base insulating layer 2. The conductor layer 3 is composed of a pair of rectangular collector portions 3a, 3b and drawn-out conductor portions 4a, 4b extending in long-sized shapes from the collector portions 3a, 3b, respectively.

Each of the collector portions 3a, 3b has a pair of lateral sides parallel to the lateral sides of the first insulating portion 2a and a pair of end sides parallel to the end sides of the first insulating portion 2a. With the bend portion B1 as the boundary, the collector portion 3a is formed in the one region of the first insulating portion 2a, and the collector portion 3b is formed in the other region of the first insulating portion 2a.

Openings H11 each having a larger diameter than that of the opening H1 are formed in respective portions, above the openings H1 of the base insulating layer 2, of the collector portion 3a. Openings H12 each having a larger diameter than that of the opening H2 are formed in respective portions, above the openings H2 of the base insulating layer 2, of the collector portion 3b.

The drawn-out conductor portion 4a is formed to linearly extend from the lateral side of the collector portion 3a to a region on the second insulating portion 2b. The drawn-out conductor portion 4b is formed to extend from the lateral side of the collector portion 3b and bend to a region on the second insulating portion 2b.

Cover layers 6a, 6b are formed on the base insulating layer 2 to cover the conductor layer 3. Each of the cover layers 6a, 6b is made of a resin composition containing carbon.

More specifically, epoxy resin containing carbon or polyimide resin containing carbon is used as the material for the cover layers 6a, 6b. Carbon is not limited to carbon black. For example, various carbon materials such as graphite can be used.

The cover layer 6a is formed to cover the collector portion 3a and the drawn-out conductor portion 4a of the conductor layer 3, and the cover layer 6b is formed to cover the collector portion 3b and the drawn-out conductor portion 4b of the conductor layer 3. The cover layer 6a is in contact with an upper surface of the base insulating layer 2 within the opening H11 of the collector portion 3a. The cover layer 6b is in contact with the upper surface of the base insulating layer 2 within the opening H12 of the collector portion 3b.

Tips of the drawn-out conductor portions 4a, 4b are not covered with the cover layers 6a, 6b, thus being exposed. The exposed portions of the drawn-out conductor portions 4a, 4b are referred to as drawn-out electrodes 5a, 5b in the following description.

### (2) Method of Manufacturing the FPC Board

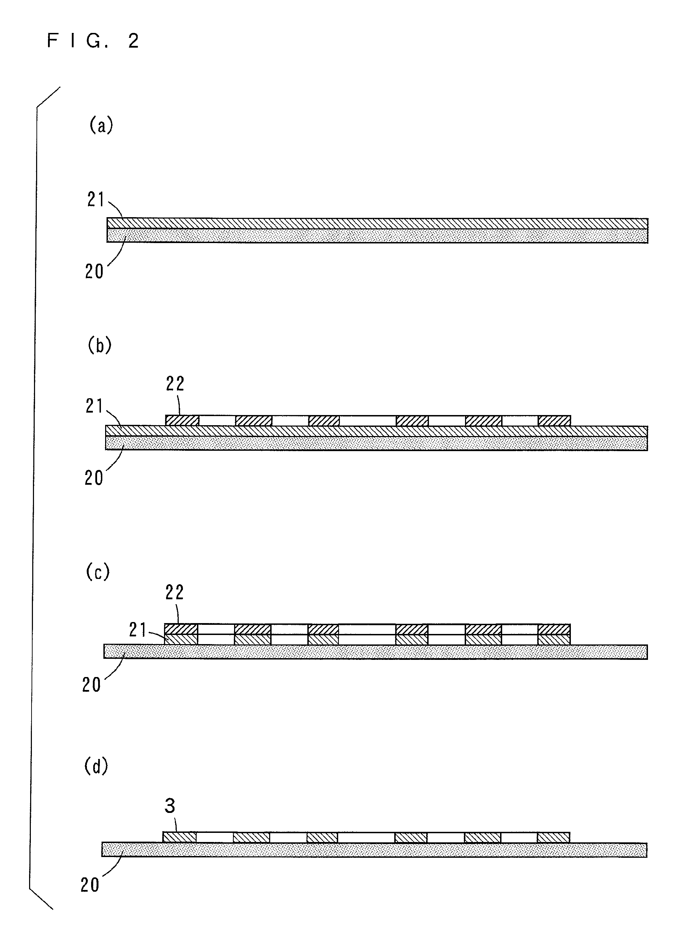

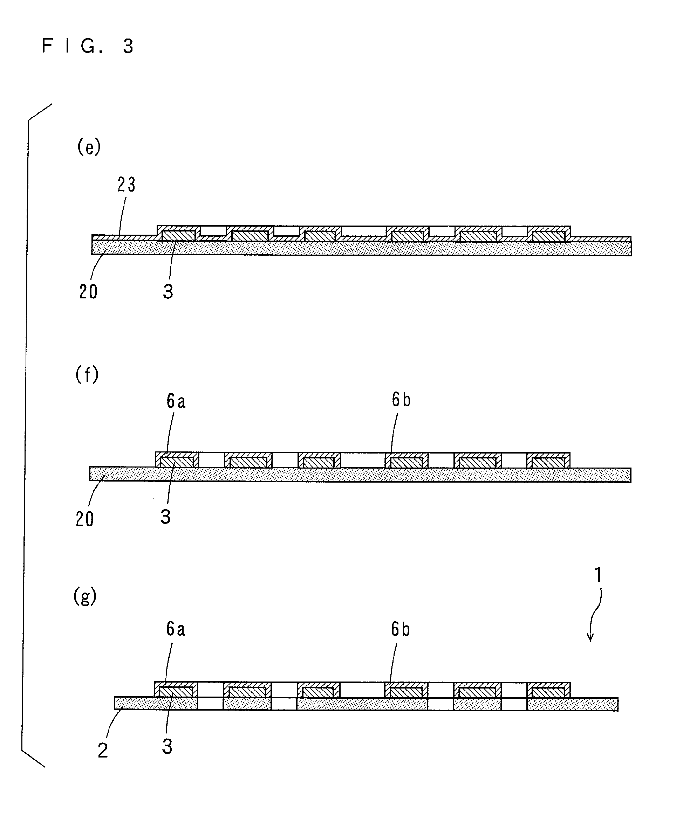

Next, description is made of a method of manufacturing the FPC board 1 shown in Fig. 1. Figs. 2 and 3 are sectional views for illustrating steps in the method of manufacturing the FPC board 1.

First, a two-layer base material composed of an insulating film 20 made of a liquid crystal polymer (LCP), and a conductor film 21 made of copper, for example, is prepared as shown in Fig. 2 (a). The thickness of the insulating film 20 is 25 µm, and the thickness of the conductor film 21 is 18 µm, for example. Another metal material such as a copper alloy and aluminum may be used as the material for the conductor layer 3.

Next, an etching resist 22 having a given pattern is formed on the conductor film 21 as shown in Fig. 2 (b). The etching resist 22 is formed by forming a resist film on the conductor film 21 using a dry film resist or the like, exposing the resist film in the given pattern, and then developing the resist film, for example.

Then, the conductor film 21 excluding a region below the etching resist 22 is removed by etching as shown in Fig. 2 (c). The etching resist 22 is subsequently removed by a stripping liquid as shown in Fig. 2 (d). In this manner, the conductor layer 3 is formed on the insulating film 20.

The cover film 23 is then formed by applying or laminating the resin composition containing carbon black, for example, on the conductor layer 3 as shown in Fig. 3 (e). The thickness of the cover film 23 is 10 µm, for example.

Next, the cover film 23 is exposed in the given pattern, followed by development, so that the cover layers 6a, 6b are formed as shown in Fig. 3 (f). The insulating film 20 is subsequently cut in a given shape as shown in Fig. 3 (g), so that the FPC board 1 composed of the base insulating layer 2, the conductor layer 3 and the cover layers 6a, 6b is completed.

The thickness of the base insulating layer 2 is preferably not less than 5 µm and not more than 50 µm, and more preferably not less than 12.5 µm and not more than 25 µm. The thickness of the conductor layer 3 is preferably not less than 3 µm and not more than 35 µm, and more preferably not less than 5 µm and not more than 20 µm. The thickness of the cover layer 6 is not less than 5 µm and not more than 25 µm, and more preferably not less than 10 µm and not more than 20 µm.

While the method of manufacturing the FPC board 1 using a subtractive method is shown in Figs. 2 and 3, the present invention is not limited to this. For example, another manufacturing method such as a semi-additive method may be used. While the cover layers 6a, 6b are formed using an exposure method in Figs. 2 and 3, the present invention is not limited to this. The cover layers 6a, 6b may be formed by forming a cover film in a given pattern using a printing technique, followed by thermal curing treatment.

### (3) The Fuel Cell Employing the FPC Board

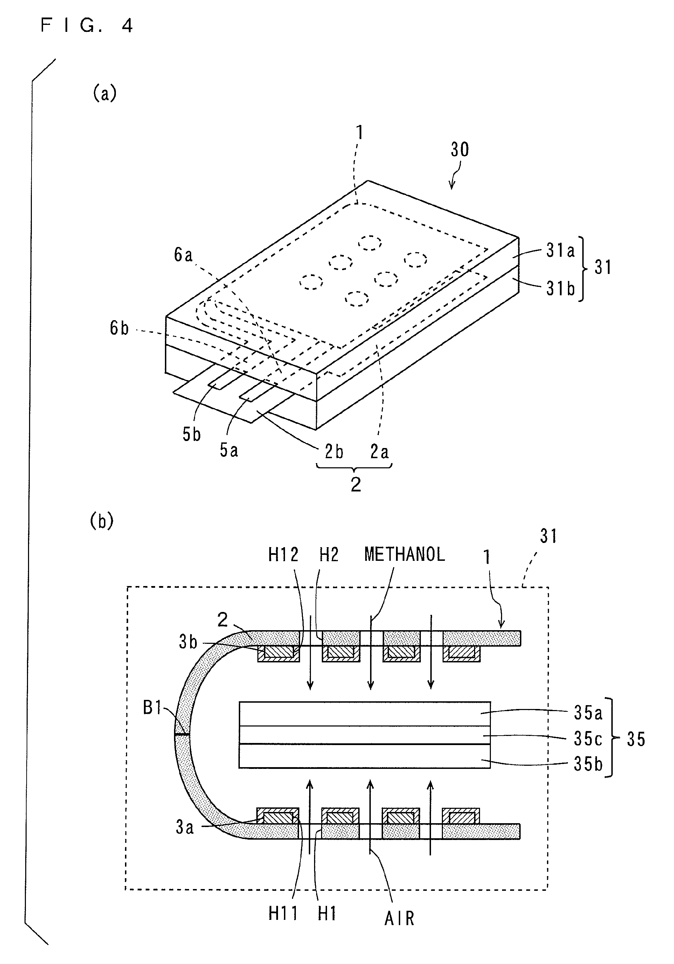

Next, description is made of the fuel cell employing the above-described FPC board 1. Fig. 4 (a) is a perspective view showing the appearance of the fuel cell employing the above-described FPC board 1, and Fig. 4 (b) is a diagram for explaining actions in the fuel cell.

As shown in Fig. 4 (a), the fuel cell 30 includes a rectangular parallelepiped housing 31 composed of half portions 31a, 31b. The FPC board 1 is sandwiched between the half portions 31a, 31b while being bent along the bend portion B1 of Fig. 1 with the one surface on which the conductor layer 3 (Fig. 1) and the cover layers 6a, 6n are formed as its inner side.

The second insulating portion 2b of the base insulating layer 2 of the FPC board 1 is drawn out from a clearance between the half portions 31a, 31b. This causes the drawn-out electrodes 5a, 5b on the second insulating portion 2b to be exposed to the outside of the housing 31. Terminals of various external circuits are electrically connected to the drawn-out electrodes 5a, 5b.

As shown in Fig. 4 (b), an electrode film 35 is arranged between the collector portion 3a and the collector portion 3b of the bent FPC board 1 in the housing 31. The electrode film 35 is composed of a fuel electrode 35a, an air electrode 35b and an electrolyte film 35c. The fuel electrode 35a is formed on one surface of the electrolyte film 35c, and the air electrode 35b is formed on the other surface of the electrolyte film 35c. The fuel electrode 35a of the electrode film 35 is opposite to the collector portion 3b of the FPC board 1, and the air electrode 35b is opposite to the collector portion 3a of the FPC board 1.

Fuel is supplied to the fuel electrode 35a of the electrode film 35 through the openings H2, H12 of the FPC board 1. Note that methanol is used as the fuel in the present embodiment. Air is supplied to the air electrode 35b of the electrode film 35 through the openings H1, H11 of the FPC board 1.

In this case, methanol is decomposed into hydrogen ions and carbon dioxide in the fuel electrode 35a, forming electrons. The formed electrons are led from the collector portion 3b to the drawn-out electrode 5b (Fig. 4 (a)) of the FPC board 1. Hydrogen ions decomposed from methanol pass through the electrolyte film 35c to reach the air electrode 35b. In the air electrode 35b, hydrogen ions and oxygen are reacted while the electrons led from the drawn-out electrode 5a (Fig. 4 (a)) to the collector portion 3a are consumed, thereby forming water. In this manner, electrical power is supplied to the external circuits connected to the drawn-out electrodes 5a, 5b.

### (4) Effects of the Present Embodiment

The liquid crystal polymer is used as the material for the base insulating layer 2 in the FPC board 1 of the present embodiment. The liquid crystal polymer has lower moisture absorption than polyimide that is generally used as the material for the base insulating layer 2.

Therefore, water vapor in the atmosphere and another liquid are prevented from being absorbed into the second insulating portion 2b of the base insulating layer 2 in the outside of the housing 31. This inhibits impurities from entering the housing 31 via the base insulating layer 2. As a result, the impurities are prevented from being mixed into methanol in the housing 31, thus suppressing degradation in performance of the fuel cell 30.

Moreover, absorption of methanol in the base insulating layer 2 is suppressed in the housing 31. This prevents methanol supplied as the fuel from leaking out of the housing 31 via the base insulating layer 2.

Furthermore, since the base insulating layer 2 does not expand due to liquid absorption, the conductor layer 3 and the cover layers 6a, 6b are not detached from the base insulating layer 2.

The surface of the conductor layer 3 is covered with the cover layers 6a, 6b in the present embodiment. Therefore, corrosion of the conductor layer 3 can be prevented even in a state where acid such as methanol is in contact with the surface of the FPC board 1 in the fuel cell 30. In addition, the cover layers 6a, 6b contain carbon, thereby ensuring electrical conductivity between the electrode film 35 and the conductor layer 3. Moreover, since an expensive material such as Au (gold) need not be used, corrosion of the conductor layer 3 can be prevented at low cost. Furthermore, ion migration of the conductor layer 3 can be suppressed by the cover layers 6a, 6b.

In present embodiment, the drawn-out electrodes 5a, 5b are arranged side by side on the same plane of the common second insulating portion 2b of the base insulating layer 2. Accordingly, in the fuel cell 30 employing the FPC board 1, the drawn-out electrodes 5a, 5b can be easily and accurately aligned with and connected to terminals of external circuits. This improves reliability of connection between the external circuits and the fuel cell 30.

### (5) Modifications

### (5-1)

A liquid crystal polymer containing carbon may be used as the material for the cover layers 6, 6b.

In this case, a liquid is inhibited from being absorbed into the cover layers 6a, 6b. This prevents impurities from entering the housing 31 via the cover layers 6a, 6b and prevents methanol from leaking out of the housing 31 via the cover layers 6a, 6b. In addition, expansion of the cover layers 6a, 6b is suppressed.

### (5-2)

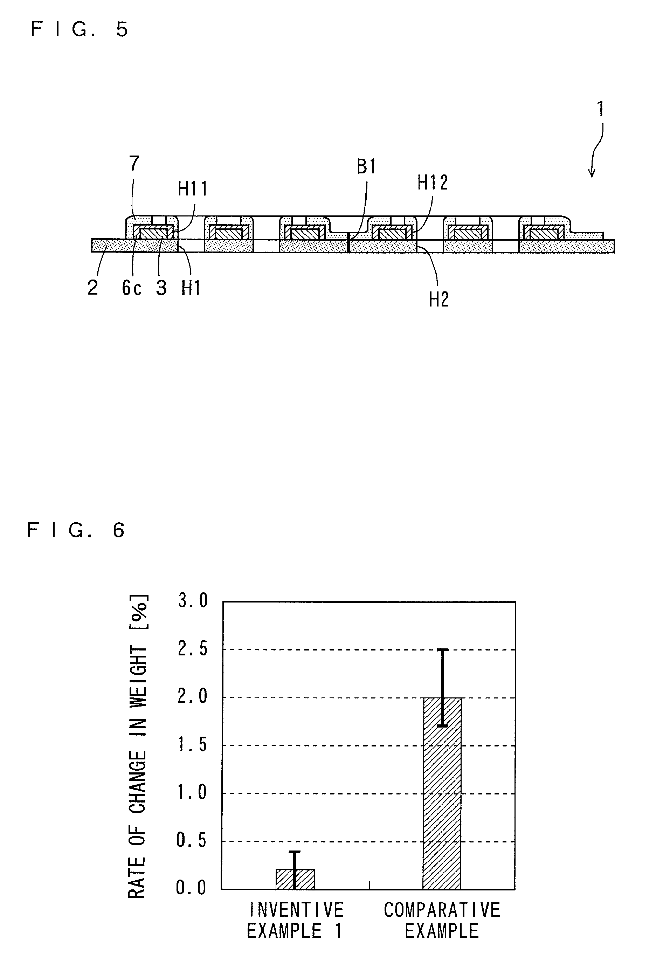

Fig. 5 is a sectional view showing a modification of the FPC board 1. Instead of the cover layers 6a, 6b, a cover layer 6c made of a metal material having high corrosion resistance such as nickel and gold is provided to cover the conductor layer 3 in the example of Fig. 5. A cover insulating layer 7 made of a resin material such as epoxy is provided to cover an interface between the cover layer 6c and the base insulating layer 2.

In this case, corrosion of the conductor layer 3 can be prevented even in a state where acid such as methanol is in contact with the surface of the FPC board 1. Since the interfaces between the cover layer 6c and the base insulating layer 2 are covered with the cover insulating layer 7, acid such as methanol is prevented from coming in contact with the conductor layer 3 via the interfaces between the cover layer 6c and the base insulating layer 2. Accordingly, corrosion of the conductor layer 3 is more reliably suppressed.

A liquid crystal polymer may be used as the material for the cover insulating layer 7. In this case, a liquid is inhibited from being absorbed into the cover insulating layer 7. This prevents impurities from entering the housing 31 via the cover insulating layer 7 and prevents methanol from leaking out of the housing 31 via the cover insulating layer 7. In addition, expansion of the cover insulating layer 7 is suppressed.

In the case of using a liquid crystal polymer as the material for the cover insulating layer 7, the above-described first and second liquid crystal polymers are preferably employed. In the case, the cover insulating layer 7 is prevented from deforming even though the temperature of the cover insulating layer 7 rises because of heat generated by a chemical reaction in the fuel cell 30.

### (6) Inventive Examples and Comparative Examples

### (6-1) Inventive Example 1

A sample having the same configuration as the FPC board of Fig. 1 except that the cover layers 6a, 6b were not provided was prepared as an inventive example 1. The above-described second liquid crystal polymer (VECSTAR manufactured by Kuraray Co., Ltd.) was used as the material for the base insulating layer 2. Copper was used as the material for the conductor layer 3. The thickness of the base insulating layer 2 was 25 µm, and the thickness of the conductor layer 3 was 18 µm.

### (6-2) Comparative Example

A sample having the same configuration as the sample of the inventive example 1 except that polyimide was used as the material for the base insulating layer 2 was prepared as a comparative example.

### (6-3) Evaluation of the Inventive Example 1 and the Comparative example

The samples of the inventive example 1 and the comparative example were immersed in a methanol solution at a 3 % concentration for two weeks, and rates of change in the weight of the FPC boards 1 were measured. In this case, the same measurement was carried out three times.

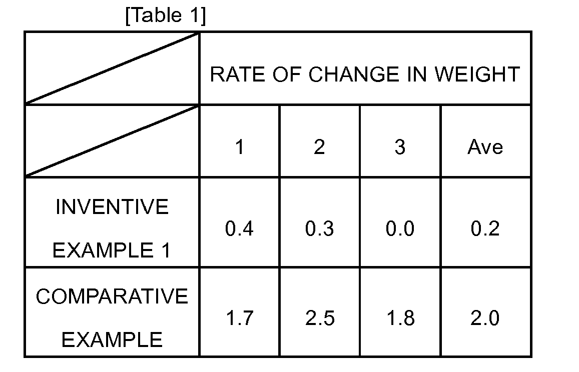

Table 1 and Fig. 6 show results of the measurement of the rates of change in the weight in the inventive example 1 and the comparative example. "Ave" in Table 1 represents an average value of the rates of change in the weight obtained through the measurement that was carried out three times (hereinafter referred to as the average rate of change in the weight). A difference between the minimum value and the maximum value of the rates of change in the weight obtained through the measurement that was carried out three times is shown by a line segment, and the average value is shown in the form of a bar graph in Fig. 6.

As shown in Table 1 and Fig. 6, the average rate of change in the weight was 0.2 % in the inventive example 1. On the other hand, the average rate of change in the weight was 2.0 % in the comparative example.

The average rate of change in the weight of the liquid crystal polymer was smaller than that of the polyimide. This shows that the moisture absorption of the liquid crystal polymer was lower than that of polyimide.

It can be seen from the results that occurrence of malfunctions due to absorption of the liquid into the base insulating layer 2 is prevented by using the liquid crystal polymer as the material for the base insulating layer 2 of the FPC board 1.

### (6-4) Inventive Examples 2, 3 and 4

The above-described first liquid crystal polymer (SUMIKASUPER manufactured by Sumitomo Chemical Co., Ltd.) was used as the material for the base insulating layer 2 in the inventive example 2.

The above-described second liquid crystal polymer (VECSTAR manufactured by Kuraray Co., Ltd. and BIAC manufactured by Japan Gore-Tex Inc.) was used as the material for the base insulating layer 2 in the inventive example 3.

The foregoing third liquid crystal polymer was used as the material for the base insulating layer 2 in the inventive example 4.

### (6-5) Evaluation of the Inventive Examples 2 to 4

Deflection temperatures under load of the base insulating layers 2 of samples of the inventive examples 2 to 4 were measured using "Test method of deflection temperature under load (JISK7191)" defined in JIS.

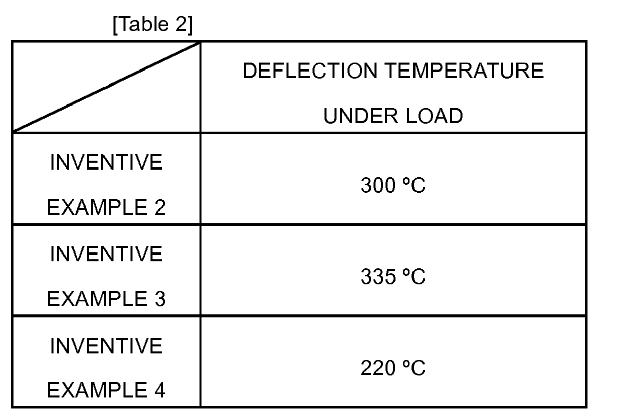

Table 2 shows results of the measurement of the deflection temperatures under load of the base insulating layers 2 in the inventive examples 2 to 4. As shown in Table 2, the deflection temperatures under load of the base insulating layers 2 of the inventive examples 2, 3 and 4 were 300 °C, 335 °C, 220 °C, respectively.

It can be seen that the deflection temperatures under load of the base insulating layers 2 formed of the first liquid crystal polymer and the second liquid crystal polymer were higher than that of the base insulating layer 2 formed of the third liquid crystal polymer. It was found as a result that using the first and second liquid crystal polymers as the materials for the base insulating layers 2 improves heat resistance of the base insulating layers 2.

### (7) Correspondences between Elements in the Claims and Parts in Embodiments

In the following paragraphs, non-limiting examples of correspondences between various elements recited in the claims below and those described above with respect to various preferred embodiments of the present invention are explained.

In the above-described embodiment, the base insulating layer 2 is an example of an insulating layer, the conductor layer 3 is an example of a conductor layer, the collector portions 3a, 3b are examples of a collector portion, the drawn-out conductor portions 4a, 4b are examples of an electrode portion, the cover layers 6a, 6b, 6c are examples of a cover layer, and the cover insulating layer 7 is an example of a cover insulating layer.

The collector portion 3a is an example of a first collector portion, the collector portion 3b is an example of a second collector portion, the drawn-out conductor portion 4a is an example of a first electrode portion, the drawn-out conductor portion 4b is an example of a second electrode portion, the electrode film 35 is an example of a cell element, and the housing 31 is an example of a housing.

As each of various elements recited in the claims, various other elements having configurations or functions described in the claims can be also used.

While preferred embodiments of the present invention have been described above, it is to be understood that variations and modifications will be apparent to those skilled in the art without departing the scope of the present invention.

## Claims

1. A printed circuit board to be used in a fuel cell, comprising:
an insulating layer made of a liquid crystal polymer; and
a conductor layer provided on said insulating layer, wherein
said conductor layer includes:
a collector portion; and
an electrode portion extending from said collector portion.

2. The printed circuit board according to claim 1, wherein said liquid crystal polymer has a molecular structure represented by a formula (1) shown below: 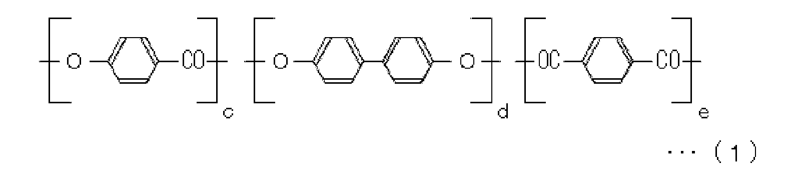 where a molar ratio [c/(c+d+e)] is not less than 0.5 and not more than 0.8, a molar ratio [d/(c+d+e)] is not less than 0.01 and not more than 0.49, and a molar ratio [e/(c+d+e)] is not less than 0.01 and not more than 0.49.

3. The printed circuit board according to claim 1, wherein said liquid crystal polymer has a molecular structure represented by a formula (2) shown below: 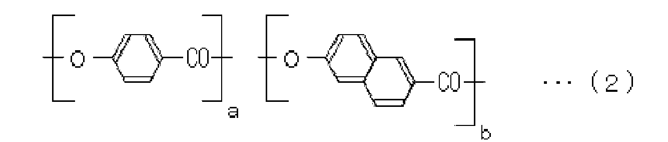 where a molar ratio [a/(a+b)] is not less than 0.5 and not more than 0.8, and a molar ratio [b/(a+b)] is not less than 0.2 and not more than 0.5.

4. The printed circuit board according to any one of the previous claims, further comprising a cover layer that is electrically conductive and resistant to acids, and is formed to cover a surface of said conductor layer.

5. The printed circuit board according to claim 4, wherein said cover layer includes a resin composition containing carbon.

6. The printed circuit board according to claim 4, wherein said cover layer is made of a metal material that is resistant to acids.

7. The printed circuit board according to claim 6, further comprising a cover insulating layer that covers an interface between said insulating layer and said cover layer.

8. A printed circuit board to be used in a fuel cell, comprising:
an insulating layer made of a liquid crystal polymer; and
a conductor layer provided on said insulating layer, wherein
said conductor layer includes:
first and second collector portions; and
first and second electrode portions extending from said first and second collector portions, respectively, and
said insulating layer and said conductor layer can be bent at a portion between said first and second collector portions such that said conductor layer is positioned on an inner side.

9. A fuel cell comprising:
a cell element;
the printed circuit board according to claim 8; and
a housing that houses said printed circuit board and said cell element, wherein
said printed circuit board is housed in said housing with said cell element arranged between said first collector portion and said second collector portion, and said first and second electrode portions are drawn out of said housing.
